# EUROPÄISCHE PATENTANMELDUNG

(11) **EP 2 385 383 A1**
(43) Veröffentlichungstag der Anmeldung: **09.11.2011**
(21) Anmeldenummer: 10162095.3
(22) Anmeldetag: 06.05.2010
(51) Int. Cl.: G01R 31/01

(54) **Werkstückträger und Verfahren zum Fertigen einer elektronischen Baugruppe**

(71) Anmelder: Siemens Aktiengesellschaft, 80333 München (DE)
(72) Erfinder: Hauser, Bernd, 92224 Amberg (DE); Pürner, Gerd, 92259 Neukirchen (DE); Schießl, Peter, 92548 Wölsendorf (DE); Stadler, Klaus, 92245 Kümmersbruck (DE)

(57) **Zusammenfassung**

Die Erfindung betrifft einen Werkstückträger (1) zur Aufnahme einer zu fertigenden elektronischen Baugruppe (2), umfassend
- einen Energiespeicher (3),
- eine Steuereinheit (4),

wobei ein erstes Kontaktmittel (11), welches ausgestaltet ist, um mit einem zweiten Kontaktmittel (12) der Baugruppe (2) eine elektrische Verbindung einzugehen, wobei Daten und eine Versorgungsspannung über die Kontaktmittel (11,12) übertragbar sind.

## Beschreibung

Die Erfindung betrifft einen Werkstückträger zur Aufnahme einer zu fertigenden elektronischen Baugruppe, umfassend einen Energiespeicher und eine Steuereinheit. Des Weiteren betrifft die Erfindung ein Verfahren zum Fertigen einer elektronischen Baugruppe, wobei ein Werkstückträger sequentiell Bearbeitungsstationen anfährt und die Baugruppe mit einem elektronischen Bauelement bestückt wird.

Werkstückträger sind aus den Schriften DE 101 50 318 A1 und DE 198 42 752 B4 bekannt.

In der produzierenden Industrie, insbesondere in den Produktionsabläufen für eine Fertigung von elektronischen Baugruppen, sind in den letzten Jahren an die Produktionsabläufe zunehmend hohe Anforderungen an eine Produktionsablaufgeschwindigkeit gestellt worden. Die produzierenden Unternehmen müssen Bestellungen immer schneller abarbeiten und die Zahl der zur produzierenden Varianten steigt zunehmend an.

Zur Fertigung von elektronischen Baugruppen werden Werkstückträger eingesetzt auf denen eine elektronische Baugruppe befestigt ist, wobei der Werkstückträger nach und nach eine Bearbeitungsstation anfährt und dabei die elektronische Baugruppe schrittweise montiert bzw. komplettiert wird. Aus der DE 198 42 752 B4 ist ein Werkstückträger zum Einsatz in ein Transfersystem für eine Fertigung von Werkstücken bekannt. Um dem bekannten Werkstückträger eine separate, individuelle Intelligenz zuzuordnen, wurde er mit einem Energiespeicher und einer Steuerungseinheit versehen, um schneller und kostengünstiger in einen Betrieb des Transfersystems zu agieren.

Bei den bekannten Werkstückträgern und Transfersystemen ist es von Nachteil, dass insbesondere für die Fertigung von elektronischen Baugruppen ein Programmieren von auf der elektronischen Baugruppe befindlichen Bausteinen eine gewisse Bearbeitungszeit in Anspruch nimmt, die es zu vermeiden gilt.

Es ist daher die Aufgabe der Erfindung den aus der DE 198 42 752 B4 bekannten Werkstückträger derart weiterzubilden, dass auf entstehende Wartezeiten durch Programmierung von Bausteinen verzichtet werden kann.

Durch einen Werkstückträger zur Aufnahme einer zu fertigenden elektronischen Baugruppe, umfassend einen Energiespeicher, eine Steuereinheit, ein erstes Kontaktmittel, welches ausgestaltet ist, um mit einem zweiten Kontaktmittel der Baugruppe eine elektrische Verbindung einzugehen, wobei Daten und eine Versorgungsspannung über die Kontaktmittel übertragbar sind, wird die Aufgabe gelöst. Es ist hierbei von Vorteil, dass eine Transportzeit vorzugsweise zur Parametrierung, Prüfung oder Initialisierung von elektronischen Bauelementen, welche auf der Baugruppe angeordnet sind, während eines Materialflusses genutzt werden kann.

Weiterhin ist es vorteilhaft, wenn der Werkzeugträger mit einem Kommunikationsmodul, welches ausgestaltet ist Parametrierdaten für ein auf der Baugruppe montiertes elektronisches Bauelement zu empfangen, versehen ist. Beispielsweise können die Baugruppen nach einem erfolgten Zusammenbau mit elektronischen Bauelementen über die Kontaktmittel, welche vorzugsweise als eine Schnittstelle in Form einer steckbaren Messerleiste ausgestaltet sind, mit ersten Initialisierungsdaten oder Prüfdaten versorgt werden.

Vorteilhafterweise weist der Werkstückträger eine Steuereinheit auf, welche mit dem Kommunikationsmodul in Verbindung steht und dabei ist die Steuereinheit dazu ausgestaltet über die Kontaktmittel Daten in das Bauelement zu laden. Die Kommunikation über das Kommunikationsmodul erfolgt dabei vorzugsweise über ein drahtloses Netzwerk, wie beispielsweise Bluetooth, ZigBee, WLAN oder dergleichen. Über einen derartigen Kommunikationskanal können an den Werkstückträger für die Baugruppe dann Daten wie z.B. eine Stromaufnahme, ein Firmwarestand, oder eine Speicherorganisation übertragen werden.

In einer weiter optimierten Ausgestaltung des Werkstückträgers, ist dieser mit seiner Steuereinheit weiterhin dazu ausgestaltet, dass vor dem Übertragen von Daten zu einem Bauelement, welches der Gruppe von Speicherbausteinen angehört, dieses initialisiert und/oder organisiert wird, so dass fehlerhafte Sektoren auf dem Speicherbaustein erkannt und gekennzeichnet werden. Einen Speicherbaustein vor einer Bestückung auf eine elektronische Baugruppe zu programmieren, ist aufgrund von speziellen Algorithmen, welche ein Prozessor verwendet, nicht möglich. Auch sind beispielsweise NAND-Speicher, ähnlich wie Festplatten aus dem PC-Bereich mit sogenannten fehlerhaften Sektoren, auch Bad-Blocks genannt, versehen. Diese werden je nach Bausteintyp anders behandelt. Mit dem Kommunikationsmodul, welches über das drahtlose Netzwerk mit einer Liniensteuerung verbunden ist, kann schnell auf eine andere Bestückungsliste bzw. geänderte Fertigungsbedingungen reagiert werden und der zu programmierende bzw. zu initialisierende Baustein kann entsprechend seiner Vorgaben mit den notwendigen Daten versorgt werden.

Ein Datentransfer von Parametrierdaten auf die Bauelemente der Baugruppe bzw. ein späteres Prüfen der Baugruppe wird dadurch unterstützt, dass der Werkstückträger in einer weiteren Ausgestaltung einen Energiespeicher aufweist, welcher als ein Doppelschichtkondensator ausgestaltet ist. Dieser Doppelschichtkondensator ist vorzugsweise kaskadiert und legt eine Versorgungsspannung über einen Spannungsregler an die Baugruppe an. Der Spannungsregler kann wiederum vorzugsweise über die Steuereinheit zum Einstellen der für die Baugruppen notwendigen Versorgungsspannungen gesteuert bzw. geregelt werden.

Um elektrische Störungen zu vermeiden, ist der Werkstückträger mit einem Kopplungsglied zur Potentialtrennung zwischen dem Energiespeicher und der Baugruppe versehen.

Die eingangs genannte Aufgabe wird ebenso durch ein Verfahren zum Fertigen einer elektronischen Baugruppe gelöst, wobei ein Werkstückträger sequentiell Bearbeitungsstationen anfährt und die Baugruppe mit einem elektronischen Bauelement bestückt wird, wobei eine elektrische Verbindung von Werkstückträger zur Baugruppe hergestellt, eine Versorgungsspannung für die Baugruppe bereitgestellt und Daten für das Bauelement bereitgestellt werden. Die Transportzeit der elektronischen Baugruppe auf dem Werkstückträger während des Produktionsprozesses über die einzelnen Bearbeitungsstationen, wird nun mit Vorteil dazu genutzt, elektronische Bauelemente mit Daten zu versorgen.

Weiterhin ist es bei dem Verfahren von Vorteil, wenn bei einem Bauelement, welches der Gruppe von Speicherbausteinen angehört, dieses initialisiert und/oder organisiert wird, so dass fehlerhafte Sektoren auf dem Speicherbaustein erkannt und gekennzeichnet werden. Nach einer derartigen Initialisierung eines Speicherbausteines schon während der Transportzeit, ist dieses zu einem späteren Zeitpunkt für eine eventuelle Prüfung bereits vorbereitet.

Diese Vorbereitung macht sich besonders vorteilhaft bemerkbar, wenn die Baugruppe vor Erreichen einer Teststation in einen betriebsfähigen Zustand versetzt wird, um Wartezeiten in der Teststation zu minimieren.

Da aufgrund der Produktvielfalt in einer Fertigung von elektronischen Baugruppen durchaus unterschiedliche Baugruppen gefertigt werden, ist es von Vorteil, wenn in dem Verfahren die Versorgungsspannung für die Baugruppe über einen Spannungsregler angepasst wird.

Weiterhin ist es vorteilhaft, um beispielsweise Störungen wie EMV-Störungen auszukoppeln, in dem Verfahren die Versorgungsspannung für die Baugruppe über ein Kopplungsglied potential getrennt an die Baugruppe heranzuführen.

Für die Fertigung der elektronischen Baugruppen mit unterschiedlichen elektronischen Bauelementen erreicht man eine besonders hohe Flexibilität, wenn über das Kommunikationsmodul Parametrierdaten für das elektronische Bauelement empfangen werden. Dabei ist vorzugsweise das Kommunikationsmodul ein als drahtloses ausgelegtes Sende- und Empfangsteil auszulegen, welches mit einer übergeordneten Liniensteuerung kommuniziert und so jeweils entsprechend des gerade im Produktionsablauf montierten Bauteils die entsprechenden Parametrierdaten für das Bauteil empfangen kann und über die Steuereinheit an das Bauteil weiterleiten kann.

Auch ist es vorteilhaft, wenn über das Kommunikationsmodul Parametrierdaten des elektronischen Bauteils abgefragt werden können, in Zweifelsfällen könnte somit über diesen Kommunikationskanal beispielsweise ein Firmware-Stand eines frei programmierbaren Bausteins abgefragt werden.

Weitere für die Erfindung relevante Gedanken sind folgende: Die Nachteile mit der unnötigen Wartezeit in einer Teststation wurden bisher dadurch gelöst, dass die Teststationen parallelisiert wurden, also mindestens zwei Teststationen in einer Linie integriert wurden, wodurch logistischer und finanzieller Mehraufwand entstanden ist. Für das Laden, von beispielsweise Firmware auf Speicherbausteinen, wurden bisher separate Arbeitsplätze mit spezieller Adaption der elektronischen Flachbaugruppen verwendet. Die Firmware wurde über einen Prozessor und eine SD-Karte auf die Baugruppe geladen. Dies geschah manuell und nicht automatisiert. Die für den Transport benötigte Laufzeit von einer Bearbeitungsstation zur nächsten Bearbeitungsstation wurde nicht für wertschöpfende Prozesse genutzt. Die Transportzeit auf den Werkstücksträgern über die einzelnen Bearbeitungsstationen hinweg, wird somit vorteilhaft für zusätzliche Prozessschritte genutzt.

Ein Ausgestaltungsbeispiel und weitere Merkmale der Erfindung zeigen die Figuren. Es zeigen die
- FIG 1: einen Werkstückträger mit einer elektronischen Baugruppe und die
- FIG 2: einen Transportfluss von Bearbeitungsstation zu Bearbeitungsstation.

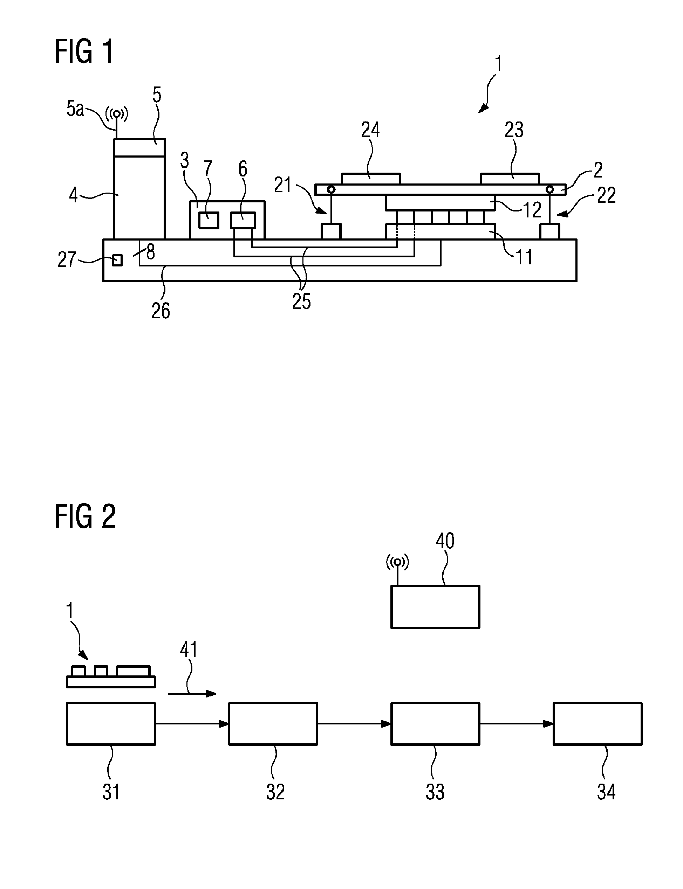

Gemäß FIG 1 ist ein Werkstückträger 1 zur Aufnahme einer zu fertigenden elektronischen Baugruppe 2 dargestellt. Die elektronische Baugruppe 2 wird über ein erstes Befestigungsmittel 21 und ein zweites Befestigungsmittel 22 auf den Werkstückträger 1 fixiert. Der Werkstückträger 1 weist unterhalb der Baugruppe 2 ein erstes Kontaktmittel 11 auf, welches mit einem zweiten Kontaktmittel 12 der Baugruppe 2 in Eingriff steht. Über die elektrische Verbindung der Kontaktmittel 11,12 kann die Baugruppe 2 mit Daten und einer Versorgungsspannung während des Transportes auf dem Werkstückträger 1 versorgt werden.

Die Versorgungsspannung für die Baugruppe 2 wird über einen Energiespeicher 3 bereitgestellt. Der Energiespeicher 3 ist dabei als ein Doppelschichtkondensator ausgelegt. Weiterhin umfasst der Energiespeicher 3, beispielsweise in einem Gehäuse, eine Kopplungseinheit 7, welche dazu ausgestaltet ist, die elektrische Baugruppe 2 von dem Energiespeicher 3 potential getrennt zu betreiben. Zur Anpassung der für die Baugruppe 2 benötigten Versorgungsspannung weist der Energiespeicher 3 in seinem Gehäuse weiterhin einen Spannungsregler 6 auf.

Der Spannungsregler 6 ist dabei über Versorgungsspannungsleitungen 25 mit dem ersten Kontaktmittel 11 verbunden. Das erste Kontaktmittel 11 weist dabei zwei Pins auf, welche die Versorgungsspannung an die entsprechenden Anschlüsse der Baugruppe 2 heranführen.

Weiterhin ist an das erste Kontaktmittel 11 eine Datenleitung 26 angeschlossen, welche achtfach ausgeführt ist. Die Datenleitung 26 stellt eine Datenverbindung zwischen einer Steuereinheit 4 und dem ersten Kontaktmittel 11 her. Die Steuereinheit 4 ist ebenfalls auf dem Werkstückträger 1 angeordnet und zusätzlich mit einem Kommunikationsmodul 5 versehen. Dieses Kommunikationsmodul 5 ist als ein drahtloses Kommunikationsmodul 5 mit einer Antenne 5a ausgelegt.

Weiterhin weist der Werkstückträger 1 einen Speicher für Daten 27 auf. Dieser ist vorzugsweise als ein RFID-Chip ausgelegt und kann bei einem Vorbeifahren an einer Bearbeitungsstation aktuelle oder zukünftige Prozessablaufdaten aufnehmen.

Die elektronische Baugruppe 2 weist nach einem Bestückungsarbeitsschritt einen programmierbaren Baustein 23 und einen RAM-Speicher 24 auf. Zur Zeitoptimierung wird nach dem Bestückungsschritt dieser beiden Bausteine 23,24 mittels der Steuereinheit 4 und der Datenleitung 26 eine Datenverbindung über die Kontaktmittel 11,12 zu den Bausteinen 23,24 hergestellt. Mit der hergestellten Datenverbindung können die Bausteine 23,24 noch in der Transportphase mit Parametrierdaten versorgt werden.

Gemäß FIG 2 ist eine Produktionslinie mit einer ersten Bearbeitungsstation 31, einer zweiten Bearbeitungsstation 32, einer dritten Bearbeitungsstation 33 und einer abschließenden Teststation 34 dargestellt. Der Produktionsablauf wird mittels einer Liniensteuerung 40 gesteuert, geregelt und überwacht. Die Liniensteuerung 40 steht über eine Funkverbindung mit dem Werkstückträger 1 in Verbindung. Der Werkstückträger 1 mit seiner elektronischen Baugruppe 2 durchläuft in einer Transportrichtung 41 den Produktionsprozess sequentiell von Bearbeitungsstation zu Bearbeitungsstation und dabei wird die Baugruppe 2 mit einem oder mehreren elektronischen Bauelementen bestückt. Hat die elektronische Baugruppe 2, beispielsweise im zweiten Bearbeitungsschritt der zweiten Bearbeitungsstation 32, die in FIG 1 erwähnten Bausteine 23,24 erhalten, so können diese bereits auf dem Weg von der zweiten Bearbeitungsstation 32 zu der dritten Bearbeitungsstation 33 mittels des Werkstückträgers 1 parametriert, getestet, initialisiert werden. Kommt die so gefertigte und bereits parametrierte elektronische Baugruppe 2 auf dem Werkstückträger 1 letztendlich an einer Teststation 34 an, so kann diese in der Teststation 34 ohne zusätzliche Wartezeiten getestet werden.

Vor dem Ankommen des Werkstückträgers 1 in der Teststation 34 wurde die elektronische Baugruppe 2 auf dem Werkstückträger 1 beim Durchfahren der dritten Bearbeitungsstation 33, nach Anschluss der Versorgungsspannung für die Baugruppe 2 und nach initialisieren der Schnittstellen auf der Baugruppe 2 und nach einem eventuellen Laden eines Arbeitsspeichers auf der Baugruppe, bereits hochgefahren und somit direkt für den Test in der Teststation 34 vorbereitet.

Durch eine Spannungsversorgung in Form von kaskadierten Doppelschichtkondensatoren, welche schnell Auf- und Nachgeladen werden können, ist es möglich bereits vor dem Funktionstest in der Teststation 34 aktiv mit der Baugruppe 2 zu kommunizieren und eventuelle Fehler bei vorherigen Prozessen schneller festzustellen und beheben zu können. Durch die Verlagerung der Prozesszeiten, welche zuvor für das Initialisieren und Laden der Baugruppe in der Teststation 34 verwendet wurden, in die bis Dato nicht genutzte Transportzeit, kann die Durchlaufzeit einer zu fertigenden Baugruppe in einem Produktionsprozess deutlich verringert werden.

## Patentansprüche

1. Werkstückträger (1) zur Aufnahme einer zu fertigenden elektronischen Baugruppe (2), umfassend
- einen Energiespeicher (3),
- eine Steuereinheit (4),
**gekennzeichnet durch**
ein erstes Kontaktmittel (11), welches ausgestaltet ist, um mit einem zweiten Kontaktmittel (12) der Baugruppe (2) eine elektrische Verbindung einzugehen, wobei Daten und eine Versorgungsspannung über die Kontaktmittel (11,12) übertragbar sind.

2. Werkstückträger (1) nach Anspruch 1, mit einem Kommunikationsmodul (5), welches ausgestaltet ist Parametrierdaten für ein auf der Baugruppe (2) montiertes elektronisches Bauelement zu empfangen.

3. Werkstückträger (1) nach Anspruch 2, wobei das Kommunikationsmodul (5) mit der Steuereinheit (4) in Verbindung steht und die Steuereinheit (4) dazu ausgestaltet ist die Parametrierdaten über die Kontaktmittel (11,12) in das Bauelement zu laden.

4. Werkstückträger (1) nach Anspruch 3, wobei die Steuereinheit (4) weiterhin dazu ausgestaltet ist, dass vor dem Übertragen von Daten zu einem Bauelement, welches der Gruppe von Speicherbausteinen angehört, dieses zu initialisieren und zu organisieren, so dass fehlerhafte Sektoren auf dem Speicherbaustein erkannt und gekennzeichnet werden.

5. Werkstückträger (1) nach einem der Ansprüche 1 bis 4, wobei der Energiespeicher (3) als ein Doppelschichtkondensator ausgestaltet ist.

6. Werkstückträger (1) nach einem der Ansprüche 1 bis 5, mit einem Spannungsregler (6) zum Einstellen der für die Baugruppe (2) notwendigen Versorgungsspannung.

7. Werkstückträger (1) nach einem der Ansprüche 1 bis 6, mit einem Kopplungsglied (7) zur Potentialtrennung zwischen dem Energiespeicher (3) und der Baugruppe (2).

8. Verfahren zum Fertigen einer elektronischen Baugruppe (2), wobei ein Werkstückträger (1) sequentiell Bearbeitungsstationen (31,32,33) anfährt und die Baugruppe (2) mit einem elektronischen Bauelement bestückt wird,
**dadurch gekennzeichnet, dass** eine elektrische Verbindung vom Werkstückträger (1) zur Baugruppe (2) hergestellt, eine Versorgungsspannung für die Baugruppe (2) bereitgestellt und Daten für das Bauelement (2) bereitgestellt werden.

9. Verfahren nach Anspruch 8, wobei bei einem Bauelement, welches der Gruppe von Speicherbausteinen angehört, dieses initialisiert und organisiert wird, so dass fehlerhafte Sektoren auf dem Speicherbaustein erkannt und gekennzeichnet werden.

10. Verfahren nach einem der Ansprüche 8 oder 9, wobei die Baugruppe (2) vor Erreichen einer Teststation (34) in einen betriebsfähigen Zustand versetzt wird, um Wartezeiten in der Teststation (34) zu minimieren.

11. Verfahren nach einem der Ansprüche 8 bis 10, wobei die Versorgungsspannung für die Baugruppe (2) über einen Spannungsregler (6) angepasst wird.

12. Verfahren nach einem der Ansprüche 8 bis 11, wobei die Versorgungsspannung für die Baugruppe (2) über ein Kopplungsglied (7) potentialgetrennt wird.

13. Verfahren nach einem der Ansprüche 8 bis 12, wobei über ein Kommunikationsmodul (5) Parametrierdaten für das elektronische Bauelement empfangen werden.

14. Verfahren nach Anspruch 13 wobei über das Kommunikationsmodul (5) Parametrierdaten des elektronischen Bauteils abgefragt werden.
